# EUROPÄISCHE PATENTSCHRIFT

(11) **EP 2 244 096 B1**
(45) Veröffentlichungstag und Bekanntmachung des Hinweises auf die Patenterteilung: **17.06.2015**
(21) Anmeldenummer: 10004199.5
(22) Anmeldetag: 20.04.2010
(51) Int. Cl.: G01R 35/00

(54) **Kalibrierverfahren für das Testen von HF-Modulen**
Calibration method for testing HF modules
Procédé de calibrage pour le test de modules HF

(30) Priorität: 23.04.2009 DE 102009018666
(43) Veröffentlichungstag der Anmeldung: 27.10.2010
(73) Patentinhaber: Airbus Defence and Space GmbH, 85521 Ottobrunn (DE)
(72) Erfinder: Schmegner, Karl-Ernst, Dr., 89278 Nersingen (DE); Höfer, Georg, 89173 Lonsee (DE)
(74) Vertreter: Meel, Thomas

(56) Entgegenhaltungen:
- WO-A2-2008/021907
- US-A- 5 434 511
- US-A1- 2008 036 469
- NING HUA ZHU: "Phase Uncertainty in Calibrating Microwave Test Fixtures" IEEE TRANSACTIONS ON MICROWAVE THEORY AND TECHNIQUES, IEEE SERVICE CENTER, PISCATAWAY, NJ, US, Bd. 47, Nr. 10, 1. Oktober 1999 (1999-10-01), XP011037770 ISSN: 0018-9480
- MEYS: 'A triple-through method for characterizing test fixtures' I.E.E.E. TRANSACTIONS ON MICROWAVE AND TECHNIQUES Bd. 36, Nr. 6, 01 Juni 1988 - 01 Juni 1988, NY, USA, Seiten 1043 - 1046, XP001458975
- XIANMING QING ET AL: "Impedance Characterization of RFID Tag Antennas and Application in Tag Co-Design" IEEE TRANSACTIONS ON MICROWAVE THEORY AND TECHNIQUES, IEEE SERVICE CENTER, PISCATAWAY, NJ, US, Bd. 57, Nr. 5, 1. Mai 2009 (2009-05-01), Seiten 1268-1274, XP011254490 ISSN: 0018-9480

## Beschreibung

Die Erfindung betrifft ein Kalibrierverfahren für das Testen von HF-Modulen, z.B. einem T/R-Modul für aktive phasengesteuerte Antennen (AESA: Active Electronically Scanned Antennas).

Für die Steuerung der T/R-Module in aktiven phasengesteuerten Antennen muss deren elektrisches Verhalten sowohl im Empfangs- als auch im Sendemode für jedes T/R-Modul der Antenne (in der Regel mehr als 1000 T/R-Module pro Antenne) im vorgegebenen Frequenzbereich nach Betrag und Phase bekannt sein. Zur Vermessung der T/R-Module werden geeignete Testhalterungen verwendet.

Bei T/R-Modulen, die hinsichtlich ihrer HF-Tore unsymmetrisch sind, (z.B. ein T/R-Modul mit CIN:APSE^{®} kompatiblen Kontaktpad an einem Ende und einem Strahler-element am gegenüberliegenden Ende) werden zur Kalibrierung der Testhalterung entsprechend ausgebildete unsymmetrische Kalibrierstandards verwendet. Die Streuparameter von unsymmetrisch aufgebauten Messobjekten konnten jedoch bisher mit einem Netzwerkanalysator (dieser geht von einer identischen Geometrie der Messtore aus) nur mit erhöhtem Aufwand und relativ ungenau messtechnisch bestimmt werden.

US 2008/0036469 A1, WO 2008/021907 sowie Ning Hua Zhu:"Phae uncertainty in calibrating microwave test fixtures", IEEE, XP11037770, 10.10.1999 beschreiben jeweils Kalibrierverfahren für Testhalterungen zum Testen von HF-Modulen nach dem Oberbegriff des Patentanspruchs 1 unter Durchführung einer TRL-Kalibrierung der Testhalterung mit anschließendem De-Embedding, d.h. Ermittlung der Streuparameter des bei der TRL-Kalibrierung verwendeten TRL-Kalibrierstandards an einem von der Testhalterung separaten Messplatzes mit anschließender Rückgängigmachung der TRL-Kalibrierung zugrundeliegenden Bezugsebenenverschiebung. Im letztgenannten Dokument wird zusätzlich zwischen symmetrischen und unsymmetrischen Testhalterungen unterschieden, in dem für diese beiden Fälle unterschiedliche Arten und Mengen von Kalibrierstandards verwendet werden. In der genannten WO 2008/021907 werden in einer Ausführung die beiden Hälften eines Kalibrierstandards getrennt vermessen.

Der Erfindung liegt die Aufgabe zugrunde, ein Kalibrierverfahren speziell für eine Testhalterung zum Testen von HF-Modulen, welche hinsichtlich ihrer HF-Tore unsymmetrisch aufgebaut sind, mit einfacher Bedienbarkeit zu schaffen.

Diese Aufgabe wird mit dem Kalibrierverfahren nach Patentanspruch 1 gelöst. Vorteilhafte Ausführungen der Erfindung sind Gegenstand eines Unteranspruchs.

Gemäß der Erfindung wird die Kalibrierung der Testhalterung für das HF-Modul in einen direkt an der Testhalterung durchzuführenden Teil, bei dem eine TRL-Kalibrierung mit einem geeigneten Satz von TRL-Kalibrierstandards THRU, REFLECT und LINE durchgeführt wird, und einen in einem separaten Messplatz durchzuführenden Teil zur Bestimmung von Korrekturgrößen durchgeführt. Dabei erfordert nur der an dem separaten Messplatz (typischerweise in einem Messlabor) durchzuführende Teil erfahrenes Messpersonal. Der erste, an der Testhalterung durchzuführende Teil, kann ohne großen messtechnischen Aufwand auch von geringer qualifiziertem Bedienpersonal durchgeführt werden. Die Kalibrierung an der Testhalterung erfordert dabei lediglich die Einlegung der TRL-Kalibrierstandards in den Prüfsockel der Testhalterung. Die Kalibrierung (wie auch die Verifizierung - siehe weiter unten) erfordert somit dieselben Bedienschritte wie der eigentliche Messvorgang. Es müssen keine elektrischen Verbindungen aufgetrennt werden. Die elektrischen Parameter der koaxialen Kabel bleiben unverändert (Kabel werden nicht bewegt) und die Stecker unterliegen keinem mechanischen Verschleiß.

Der Zustand der Testhalterung kann aufgrund des bedienerfreundlichen Grundkonzepts jederzeit ohne größeren Aufwand mit einem Verifizierungs-Standard überprüft werden. Dazu muss lediglich ein Verifizierungs-Standard eingelegt und vermessen werden, bevor Maßnahmen zur Behebung eingeleitet werden.

Mit dem erfindungsgemäßen Kalibrierverfahren ist es nunmehr möglich, die Kalibrierung für Testhalterungen für T/R-Module mit ungleichen HF-Toren wesentlich zu vereinfachen.

Die erfindungsgemäße Kalibrierung eignet sich aufgrund der erwähnten Vorteile insbesondere auch für ein automatisches Testen von größeren Stückzahlen im Rahmen einer Serienfertigung von T/R Modulen.

Die Erfindung wird-anhand-konkreter-Ausführungsbeispiele unter Bezugnahme auf Figuren näher erläutert. Es zeigen:
- Fig. 1: eine Testhalterung zum Vermessen eines hinsichtlich seiner HF-Tore symmetrischen T/R-Moduls;
- Fig. 2: einen symmetrischen Kalibrierstandard mit zwei Kontaktpads als HF-Tore;
- Fig. 3: eine Testhalterung zum Vermessen eines hinsichtlich seiner HF-Tore unsymmetrischen T/R-Moduls;
- Fig. 4: ein unsymmetrischer Kalibrierstandard mit Kontaktpad und Strahlerelement als HF-Tore;
- Fig. 5: ein erster, aus dem Kalibrierstandard nach Fig. 4 abgeleiteter Kalibrierstandard mit zwei Kontaktpads;
- Fig. 6: ein zweiter, aus dem Kalibrierstandard nach-Fig: 4-abgeleiteter Kalibfler-standard mit zwei Strahlerelementen;
- Fig. 7: eine Anordnung zur Vermessung eines Kalibrierstandards nach Fig. 6:
a) in Seitenansicht,
b) in Draufsicht.

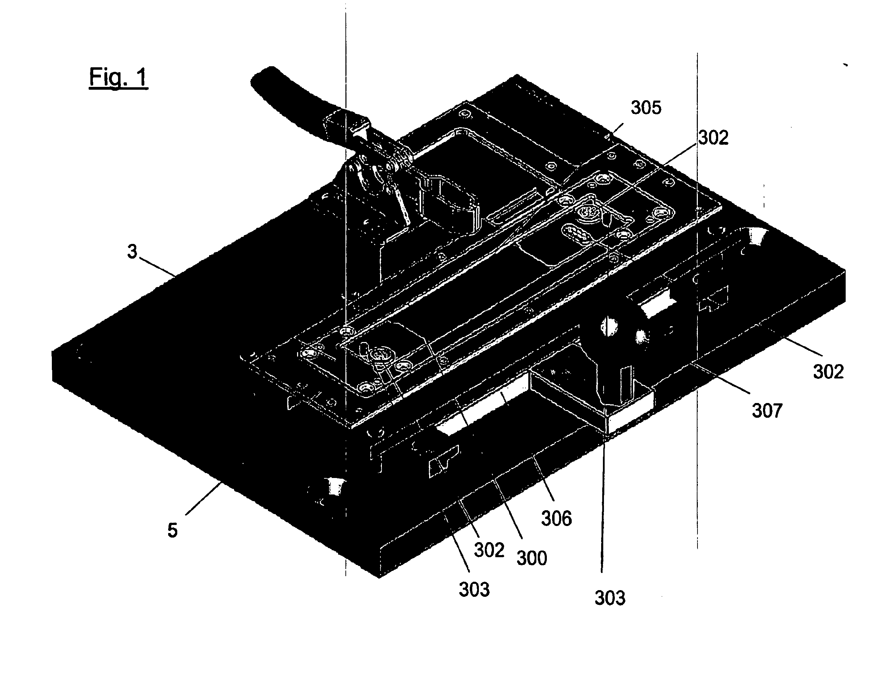

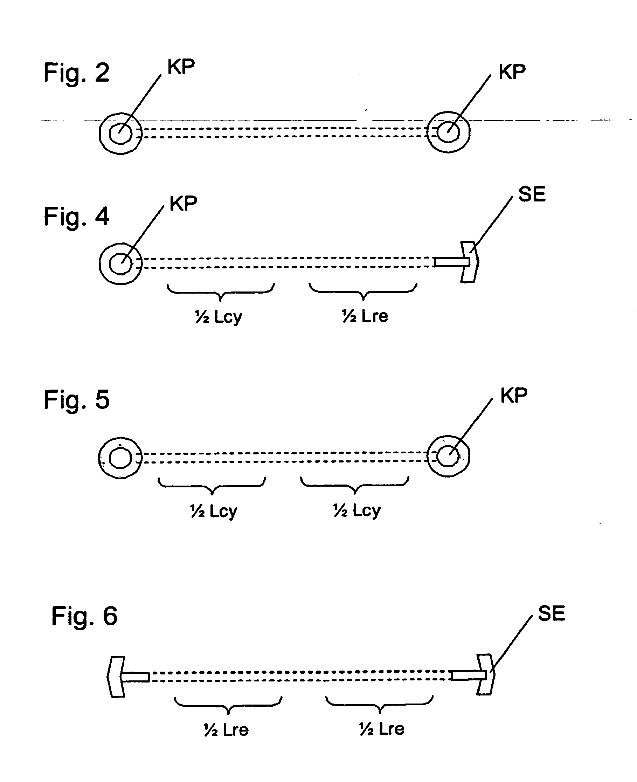

Die weitere Beschreibung erfolgt anhand der Fig. 1 und 2 zunächst anhand eines - nicht erfindungsgemäßen - Kalibrierverfahrens für eine Testhalterung zum Testen von HF-Modulen, welche hinsichtlich ihrer HF-Tore symmetrisch aufgebaut sind, bevor darauf aufbauend das erfindungsgemäße Verfahren zum Testen unsymmetrischer HF-Module erläutert wird.

Fig. 1 zeigt ein erstes Beispiel für den Prüfsockel einer zu kalibrierenden Testhalterung für die Vermessung eines T/R-Moduls. Das T/R-Modul ist hinsichtlich seiner HF-Tore, die hier eingangs- und ausgangsseitig als Kontaktpads ausgebildet sind, symmetrisch aufgebaut, d.h. an jedem Ende befindet sich identische HF-Tore (generell ist eine vorhandene Symmetrie eines Prüflings immer auf die Mitte der Verbindungslinie der HF-Tore bezogen). Fig. 1 zeigt die Testhalterung in einem Zustand, bevor ein zu vermessendes T/R-Modul in die dafür vorgesehene wannenförmige Vertiefung 300 einer vertikal beweglichen Kontaktiereinheit 3 eingelegt worden ist. Die Kontaktiereinheit 3 ist auf einem Leitungssubstrat 5 angeordnet und weist Kontaktelemente, hier Federkontaktstifte 302, für die Kontaktierung des T/R-Moduls auf. Wenn ein T/R-Modul eingelegt wird (dabei sorgen Passstifte 303 für eine eindeutige Ausrichtung), liegt es auf der zentralen (unbeweglichen) Temperiereinheit 305 auf, hat aber zunächst noch keinen Kontakt zu der Testhalterung. Ein solcher Kontakt wird erst hergestellt, in dem eine Schiebeeinrichtung 306 an ihrem Schiebehebel 307 in Richtung auf das eingelegte T/R-Modul geschoben wird, was zu einer vertikalen Bewegung der Kontaktiereinheit 3 in Richtung auf das T/R-Modul führt. Beim Anschlag der Kontaktiereinheit werden die Federkontaktstifte 302 der Kontaktiereinheit gleichzeitig mit den komplementären Kontaktelementen (hier: Kontaktpads) des T/R-Moduls kontaktiert. Alle erforderlichen Kontakte können somit in einem Arbeitsgang sicher und gleichzeitig geschlossen werden. Durch die Verwendung der Federkontaktstifte kann darüber hinaus die Kontaktierung unabhängig vom individuellen Modul oder Kalibrierelement nahezu identisch gleichartig erfolgen. Ein Einfluss des Bedienpersonals auf die Güte der Messergebnisse oder Kalibrierung ist somit ausgeschlossen.

Die Kalibrierung von Testhalterungen für ein T/R-Modul, das wie das oben im Zusammenhang mit Fig. 1 beschriebene T/R-Modul bezüglich seiner HF-Tore symmetrisch aufgebaut ist, wird wie folgt durchgeführt:

### Schritt 1: Messung der Streuparameter der T/R-Module

Zur Bestimmung der Streuparameter der T/R-Module kann z.B. ein vektorieller Netzwerkanalysators (VNA) verwendet werden. Die für die Korrektur der Messwerte im VNA erforderlichen Fehlerterme (z.B. 12 Term Fehlermodell) werden mit Hilfe einer TRL-Kalibrierung der Testhalterung im CW-Mode und im Pulse-Mode bestimmt. Zur Durchführung der TRL-Kalibrierung wird in die Testhalterung ein Satz passender Kalibrierstandards für THRU, LINE, und REFLECT verwendet. Der THRU-Kalibrierstandard ist in Fig. 2 schematisch dargestellt. Analog zum zu vermessenden T/R-Modul ist er hinsichtlich seiner HF-Tore symmetrisch aufgebaut und umfasst zwei identische Kontaktpads KP an jeder Seite. Zur Kalibrierung werden die genannten Kalibrierstandards in den Prüfsockel der Testhalterung eingebracht.

Die im VNA zur Kalibrierung der Testhalterung verwendeten Algorithmen setzen zum Beispiel für den Standard THRU implizit eine verlustlose Leitung (elektrische Länge Null) voraus. Die Kontaktierebene und damit die Bezugsebene für die Messung der Streuparameter der T/R-Module befindet sich jedoch an den Kontaktpads KP und damit am Anfang bzw. Ende des Prüfsockels in der Testhalterung. Das T/R-Modul hat eine endliche mechanische Länge, so dass zur Verbindung der Kontaktierebenen eine Durchverbindung (THRU) mit einer mechanischen und damit elektrischen Länge ungleich Null verwendet werden muss. Demzufolge verschiebt eine Kalibrierung mit den für die Testhalterung geeigneten Standards die Bezugsebene in dessen Mitte auf THRU/2. Demgemäß handelt es sich bei dem THRU-Standard um einen nicht-optimalen Kalibrierstandard im Zusammenhang mit einer TRL-Kalibrierung und analoge Überlegungen gelten für die anderen Kalibrierstandards REFLECT und LINE.

Eine mit derartigen nicht-optimalen Kalibrierstandards THRU, REFLECT, LINE durchgeführte TRL-Kalibrierung führt bei der Messung der Streuparameter des T/R-Moduls zu fehlerhaften Ergebnissen. Um die Verschiebung der Bezugsebene wieder rückgängig machen zu können, werden im nächsten Schritt entsprechende Korrekturparameter berechnet.

### Schritt 2: Bezugsebenenverschiebung im Prüfsockel der Testhalterung

Zur Verschiebung der Bezugsebene von der Mitte des Prüfsockels auf die Kontaktierstellen am T/R-Modul werden in einer separaten Messung die Streuparameter des bei der Kalibrierung in der Testhalterung verwendeten THRU-Standards (Fig. 2) bestimmt. Diese können z.B. an einem Prober-Messplatz mit einem VNA ermittelt werden, der zuvor einer OSLT-Kalibrierung mit On-Wafer-Kalibrierstandards unterzogen wird.

Die Halterungen der Messspitzen des Prober-Messplatzes können mechanisch verschoben und damit, im Gegensatz zur oben beschriebenen Messung an der Testhalterung, an die Geometrie (mechanische Länge) des Prüflings (Kalibrierstandard oder T/R-Modul) angepasst werden.

Aus den für den THRU-Standard ermittelten Streuparametern werden Korrekturparameter ermittelt, mit denen die in der Testhalterung am T/R-Modul gemessenen Streuparameter nach Betrag und Phase frequenzabhängig korrigiert werden. Die Kalibrierung ist somit abgeschlossen.

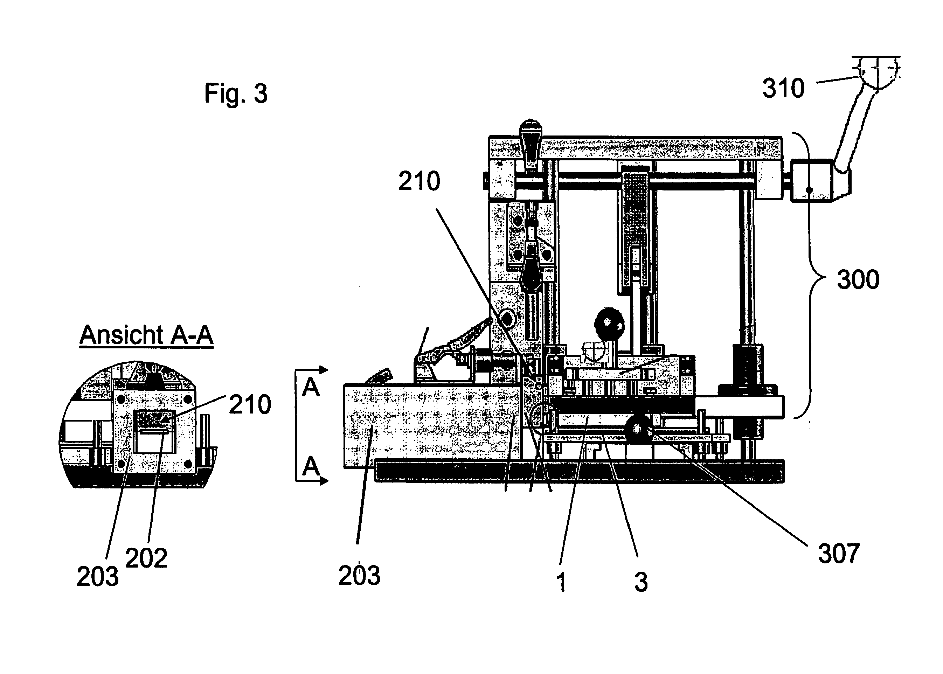

Fig. 3 zeigt ein weiteres Beispiel für eine zu kalibrierende Testhalterung zur Vermessung eines T/R-Moduls. Das zu testende T/R-Modul 1 ist hinsichtlich seiner HF-Tore unsymmetrisch aufgebaut, d.h. an jedem Ende befindet sich ein HF-Tor unterschiedlichen Typs.

Eingangsseitig erfolgt die Kontaktierung ähnlich wie in Fig. 1 durch die mechanische Führung einer Kontaktiereinheit 3, welche nach Erreichen einer definierten Endposition das zu prüfende T/R-Modul 1 kontaktiert, in dem Federkontaktstifte das Kontaktpad des T/R-Moduls berühren. Die mechanische Führung wird mittels einer Schiebeeinrichtung über den Schiebehebel 307 realisiert.

Das ausgangsseitige HF-Tor wird durch ein Strahlerelement 202 gebildet. Dieses Strahlerelement 202 ist von einer schalenförmigen Schirmung 210 umgeben und strahlt in die Öffnung eines Hohlleiters 203. Ein sich an den Hohlleiter 203 anschließender quadratischer Hohlleiter (in Fig. 3 nicht dargestellt) mit Übergang auf das koaxiale Meßsystem ist Bestandteil der Testhalterung.

Die mechanische Fixierung des eingelegten T/R-Moduls 1 erfolgt mittels einer beweglichen Fixiereinheit 300, die von oben gegen das T/R-Modul 1 gepresst wird. Das Absenken der Fixiereinheit 300 erfolgt über den Kniehebel 310.

Die Kalibrierung von Testhalterungen für ein T/R-Modul, das wie das in Fig. 3 gezeigte T/R-Modul bezüglich seiner HF-Tore unsymmetrisch aufgebaut ist, wird erfindungsgemäß wie folgt durchgeführt:

### Schritt 1: Messung der Streuparameter der T/R-Module

Das Vorgehen ist grundsätzlich gleich wie bei Schritt 1 der Kalibrierung mit symmetrischen T/R-Modulen, wie oben beschrieben durch eine TRL-Kalibrierung der Testhalterung mit den Standards THRU, REFLECT, LINE. Hierbei trägt der Aufbau der Testhalterung und der Kalibrierstandards der Unsymmetrie der Messobjekte (T/R-Modul) Rechnung. Der verwendete Kalibrierstandard ist in Fig. 4 dargestellt. Er weist auf der einen Seite ein Kontaktpad KP und auf der anderen Seite ein Strahlerelement SE auf.

### Schritt 2: Bezugsebenenverschiebung im Prüfsockel der Testhalterung

Um die Bezugsebenenverschiebung messtechnisch erfassen zu können, wird der in Schritt 1 bei der Messung an der Testhalterung verwendete THRU-Standard (Fig. 4) gedanklich in der Mitte der Verbindungsleitung (½ Lcy und ½ Lre bezeichnen jeweils den Abstand der HF-Tore zur Mitte des T/R-Moduls) aufgetrennt, die Hälften jeweils symmetrisch verdoppelt (einschließlich der zwischen den HF-Toren befindlichen HF-Leitungen) und mit dieser Vorgabe mechanisch angefertigt. Die entstehenden abgeleiteten Kalibrierstandards sind in den Fig. 5 und 6 dargestellt. Aufgrund der vorstehend dargestellten Konstruktion weisen sie an jeder Seite identische Kontaktpads (Fig. 5) bzw. identische Strahlerelemente (Fig. 6) auf. Bei der symmetrischen Verdopplung handelt es sich bevorzugt um eine punktsymmetrische Verdopplung hinsichtlich des Mittelpunkts der Strecke zwischen den beiden HF-Toren oder alternativ um eine achsensymmetrische Verdopplung mit einer auf der Verbindungslinie der HF-Tore senkrecht stehenden Symmetrieachse.

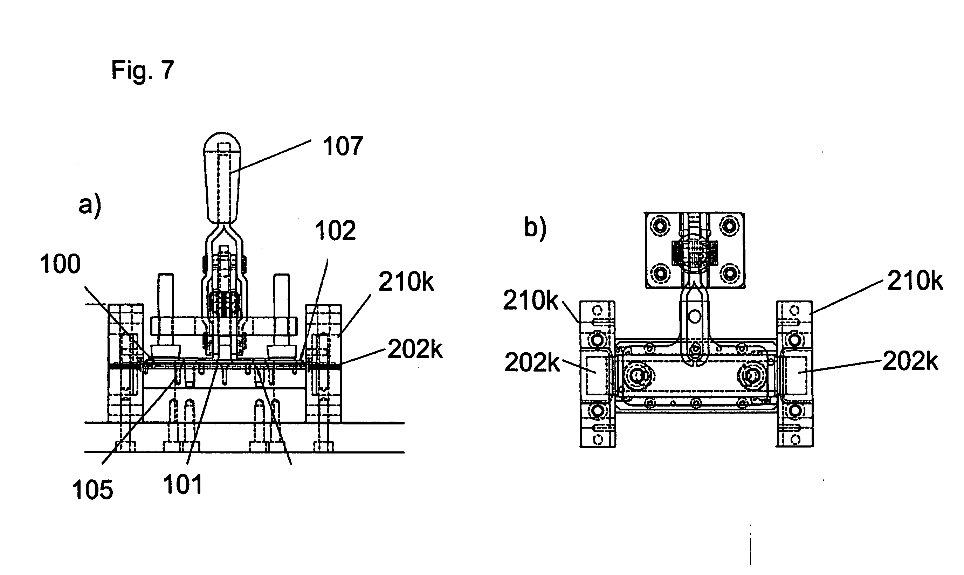

Die Streuparameter der so konstruierten, nunmehr symmetrischen Messobjekte:
a) THRU-Standard mit zwei Kontaktpads KP und einer Leitungslänge Lcy (Fig. 5), und
b) THRU-Standard mit zwei Strahlerelementen SE und einer Leitungslänge Lre (Fig. 6)
werden an zwei separaten Aufbauten ermittelt. Für den Kalibrierstandard nach Fig. 5 erfolgt die Messung vorteilhaft an dem Prober-Messplatz, wie bereits oben in Schritt 2 bei der Kalibrierung von Testhalterungen symmetrischer T/R-Module beschrieben. Für den Kalibrierstandard nach Fig. 6 erfolgt die Messung an einer symmetrischen Anordnung von Hohlleitern, die sich aus der symmetrischen Verdopplung einer Hälfte der Testhalterung (linke Hälfte der in Fig. 3 dargestellten Testhalterung) analog zur symmetrischen Verdopplung des Kalibrierstandards ergibt. Eine solche Anordnung ist in Fig. 7 beschrieben und wird weiter unten näher erläutert.
Die Messung dieses Standards erfolgt ebenfalls mit einem VNA, der einer TRL-Kalibrierung mit speziellen Hohlleiter-Standards unterzogen wird. Die Abmessungen des Hohlleiters entsprechen der Geometrie der Öffnung des Strahlerelements.

Analog zu dem Vorgehen bei der Kalibrierung von Testhalterungen für symmetrische T/R-Module werden aus den zu den beiden THRU-Standards gemäß Fig. 5 und 6 ermittelten Streuparameter Korrekturparameter ermittelt, mit denen die in der Testhalterung am T/R-Modul gemessenen Streuparameter (siehe Schritt 1) nach Betrag und Phase frequenzabhängig korrigiert werden. Dabei ist zu beachten, dass sich die Werte für die Korrektur der Messungen des T/R-Moduls jeweils zur Hälfte aus den gemessenen Streuparameter für die Kalibrierstandards nach Fig. 5 und 6 zusammensetzen.

Ein Vorteil der vorstehend beschriebenen Vorgehensweise folgt aus der Tatsache, dass die symmetrischen Kalibrierstandards gemäß Fig. 2 und Fig. 5 identisch ausgebildet sein können. Dies bedeutet, dass derselbe Kalibrierstandard für die Kalibrierung von Testhalterungen für symmetrische als auch für unsymmetrische T/R-Module (im konkreten Beispiel für T/R-Module mit und ohne Strahlerelement) verwendet werden kann. Dafür müssen folgende Bedingung eingehalten werden: Der mechanische Abstand der Kontaktpads am T/R-Modul ohne Strahlerelement legt die Länge des (symmetrischen) THRU-Kalibrierstandards gemäß Fig. 2 fest. Die Länge und Form der halben Leitung (½ Lcy) muss im (unsymmetrischen) THRU-Kalibrierstandard mit Strahlerelement (Fig. 4) berücksichtigt werden. Diese Vorgehensweise stellt die Verwendbarkeit des THRU-Standards ohne Strahlerelement (Fig. 2) für die Bezugsebenenverschiebung an den T/R-Modulen mit Strahlerelement sicher.

Der Kalibrierstandard gemäß Fig. 6 setzt sich zusammen aus einem Strahlerelement an jeder Seite und einer dazwischen liegenden Leitung der Länge Lre. Die Länge ½ Lre ergibt sich aus dem THRU-Standard nach Fig. 4.

Die zur Kalibrierung vorgesehenen TRL-Kalibrierstandards werden in den Prüfsockel der Testhalterung eingelegt und müssen deshalb eine den T/R-Modulen entsprechende Berandung aufweisen. Darüber hinaus müssen sie die für die TRL-Kalibrierung vorgesehenen elektrischen Vorgaben erfüllen.

Wie bereits oben erwähnt, wird zur messtechnischen Bestimmung des Verhaltens für den Kalibrierstandard mit zwei Strahlerelementen (Fig. 6) eine spezielle Vorrichtung zur mechanischen Aufnahme und Fixierung dieses Standards angefertigt. Dieser ergibt sich durch symmetrische Verdopplung derjenigen Seite der Testhalterung (Fig. 3), die sich auf das Strahlerelement 202 bezieht. Die Verdopplung betrifft selbstverständlich nur diejenigen Bauteile der Testhalterung, die für das Strahlerelement sowie für die Leitung der davon abgestrahlten HF-Strahlung relevant sind. Eine derartige Messeinrichtung ist beispielhaft in Fig. 7 dargestellt. In eine Aufnahmeplatte 101, die auf einem Auflageblock 105 angeordnet ist, wird der zu vermessende Kalibrierstandard 100 (dargestellt in Fig. 6) eingelegt. Durch Betätigung des Kniehebels 107 drückt eine mechanische Fixiervorrichtung auf die Abdeckplatte 102, um den Kalibrierstandard 100 mechanisch in seiner Position zu sichern.

Der Kalibrierstandard 100 weist an beiden Enden ein Strahlerelement 202k auf, das jeweils von einer schalenförmigen Schirmung 210k umgeben ist. Eine solche Schirmung 210k ist auch auf der linken Seite der Vorrichtung nach Fig. 3 vorhanden, aus der die in Fig. 7 gezeigte Vorrichtung abgeleitet ist. Die Schirmung 210k vermittelt den Übergang zu jeweils einem Hohleiter (in Fig. 7 nicht dargestellt - jedoch analog zu Bezugsziffer 203 der Vorrichtung nach Fig. 3, von der, wie beschrieben, diese Vorrichtung abgeleitet ist), in den die HF-Strahlung des Strahlerelements 202k eingespeist wird.

Wie man aus Fig. 7 erkennt, ist die dargestellte Vorrichtung entsprechend dem zu vermessenden Kalibrierstandard 100 symmetrisch bezüglich der Mitte des Kalibrierstandards 100 aufgebaut.

## Patentansprüche

1. Kalibrierverfahren für eine Testhalterung zum Testen von HF-Modulen, welche hinsichtlich ihrer HF-Tore unsymmetrisch aufgebaut sind, mit folgenden Schritten:
- TRL-Kalibrierung der Testhalterung mittels eines Satzes nicht-optimaler THRU-, REFLECT- und LINE-Kalibrierstandards, die dazu in den Prüfsockel der Testhalterung eingelegt werden, wobei die Verwendung der nicht-optimalen Kalibrierstandards zu einer Verschiebung der Bezugsebene hinsichtlich der gemessenen Streuparameter in der Testhalterung führt,
- Ermittlung der Streuparameter von aus dem nicht-optimalen THRU-Kalibrierstandard abgeleiteten THRU-Kalibrierstandards, jeweils in von der zu kalibrierenden Testhalterung separaten Messplätzen,
- Rückgängigmachung der Bezugsebenenverschiebung, in dem aus der Messung an den separaten Messplätzen Korrekturparameter ermittelt werden, mit der die in der Testhalterung am HF-Modul gemessenen Streuparameter korrigiert werden,
**dadurch gekennzeichnet, dass**
- die aus dem nicht-optimalen THRU-Kalibrierstandard abgeleiteten Kalibrier-standards erzeugt werden, in dem jeweils eine Hälfte symmetrisch verdoppelt wird, und wobei die Ermittlung der Streuparameter der derart abgeleiteten Kalibrierstandards an Messplätzen erfolgt, die aus der zu kalibrierenden Testhalterung abgeleitet sind, in dem jeweils eine Hälfte der Testhalterung symmetrisch verdoppelt wird, und
- die für die Rückgängigmachung der Bezugsebenenverschiebung verwendeten Korrekturparameter sich jeweils zur Hälfte aus den gemessenen Streuparametern der beiden abgeleiteten Kalibrierstandards zusammensetzen.

2. Kalibrierverfahren nach Anspruch 1, **dadurch gekennzeichnet, dass** die HF-Tore der HF-Module als Kontaktpads sowie als Strahlerelemente vorliegen.

## Claims

1. Calibration method for a test holder for testing RF modules which have an asymmetrical construction with respect to their RF ports, having the following steps:
- TRL calibration of the test holder using a set of non-optimal THRU, REFLECT and LINE calibration standards which, for this purpose, are inserted into the test socket of the test holder, the use of the non-optimal calibration standards resulting in a shift of the reference plane with respect to the measured scattering parameters in the test holder,
- determination of the scattering parameters by THRU calibration standards derived from the non-optimal THRU calibration standard, in each case in measuring stations separate from the test holder to be calibrated,
- reversal of the reference plane shift by determining correction parameters from the measurement at the separate measuring stations, with which the scattering parameters measured in the test holder on the RF module are corrected,
**characterized in that**
- the calibration standards derived from the non-optimal THRU calibration standard are generated by symmetrically doubling one half in each case, the scattering parameters of the calibration standards derived in this manner being determined at measuring stations which are derived from the test holder to be calibrated by symmetrically doubling one half of the test holder in each case, and
- the correction parameters used to reverse the reference plane shift are each half composed of the measured scattering parameters of the two derived calibration standards.

2. Calibration method according to Claim 1, **characterized in that** the RF ports of the RF modules are in the form of contact pads and antenna elements.

## Revendications

1. Procédé de calibrage pour un gabarit de test pour tester des modules HF, qui sont construits de manière asymétrique en termes de leurs portails HF, comprenant les étapes suivantes :
- calibrage TRL du gabarit de test au moyen d'un ensemble de normes de calibrage THRU, REFLECT, et LINE non optimales, qui sont entrées à cet effet dans le socle de mesure du gabarit de test, l'utilisation des normes de calibrage non optimales conduisant à un déplacement du plan de référence en termes des paramètres de diffusion mesurés dans le gabarit de test,
- détermination des paramètres de diffusion par des normes de calibrage THRU dérivées de la norme de calibrage THRU non optimale, à chaque fois à des postes de mesure séparés du gabarit de test à calibrer,
- annulation du déplacement du plan de référence, des paramètres de correction étant déterminés à partir de la mesure au niveau des postes de mesure séparés, avec laquelle les paramètres de diffusion mesurés dans le gabarit de test sur le module HF sont corrigés,
**caractérisé en ce que**
- les normes de calibrage dérivées de la norme de calibrage THRU non optimale sont générées, en doublant à chaque fois symétriquement une moitié, et la détermination des paramètres de diffusion des normes de calibrage ainsi dérivées s'effectuant au niveau de postes de mesure qui sont dérivés du gabarit de test à calibrer, en doublant à chaque fois symétriquement une moitié du gabarit de test, et
- les paramètres de correction utilisés pour l'annulation du déplacement du plan de référence se composent à chaque fois pour moitié des paramètres de diffusion mesurés des deux normes de calibrage dérivées.

2. Procédé de calibrage selon la revendication 1, **caractérisé en ce que** les portails HF des modules HF se présentent sous forme de plages de contact ainsi qu'en tant qu'éléments rayonnants.
